# EUROPÄISCHE PATENTSCHRIFT

(11) **EP 3 459 110 B1**
(45) Veröffentlichungstag und Bekanntmachung des Hinweises auf die Patenterteilung: **26.08.2020**
(21) Anmeldenummer: 16733971.2
(22) Anmeldetag: 01.07.2016
(51) Int. Cl.: H01L 23/40, H01L 23/473

(54) **KÜHLDOSENEINHEIT UND LEISTUNGSELEKTRONISCHE EINRICHTUNG MIT KÜHLDOSENEINHEIT**
COOLING BOX UNIT AND POWER ELECTRONICS DEVICE HAVING A COOLING BOX UNIT
UNITÉ DE BOÎTE DE REFROIDISSEMENT ET SYSTÈME ÉLECTRONIQUE DE PUISSANCE DOTÉ D'UNE UNITÉ DE BOÎTE DE REFROIDISSEMENT

(43) Veröffentlichungstag der Anmeldung: 27.03.2019
(73) Patentinhaber: Siemens Aktiengesellschaft, 80333 München (DE)
(72) Erfinder: DELCHMANN, Wilhelm, 91093 Hessdorf (DE); FREY, Alexander, 90431 Nürnberg (DE); HÜTTNER, Sebastian, 90459 Nürnberg (DE); KÜBEL, Thomas, 91056 Erlangen (DE); ZUBER, Michael, 90459 Nürnberg (DE)
(86) Internationale Anmeldenummer: PCT/EP2016/065587
(87) Internationale Veröffentlichungsnummer: WO 2018/001525

(56) Entgegenhaltungen:
- EP-A1- 0 234 021
- WO-A2-2009/052817
- DE-A1- 3 408 771
- DE-A1- 4 301 865
- DE-C- 967 450
- DE-U1- 9 212 752

## Beschreibung

Die Erfindung betrifft eine Kühldoseneinheit zum Entwärmen einer elektrischen Komponente mit einem metallischen Kühlkörper zur Herstellung einer thermisch leitenden Verbindung mit der elektrischen Komponente und wenigstens einem Kühlkanal zur Führung eines Kühlmittels, wobei der Kühlkörper den wenigstens einen Kühlkanal zumindest teilweise ausbildet.

Eine solche Kühldoseneinheit ist beispielsweise aus der EP 0 021 269 A2 bekannt. Die bekannte Kühldoseneinheit umfasst zwei Kühlkörper, die beidseitig eines plattenförmigen Kerns angeordnet sind. Jeder Kühlkörper der bekannten Kühldoseneinheit weist eine Ausnehmung auf, die vom Kern teilweise begrenzt ist und einen Strömungskanal für ein Kühlmedium ausbildet. Der Kühlkörper ist für eine gute Wärmeleitung aus einem Metall hergestellt.

Die bekannte Kühldoseneinheit wird zur Kühlung von elektrischen Komponenten in Form von Scheibenthyristoren bzw. Scheibendioden eingesetzt. Die zu kühlenden elektrischen Komponenten werden dazu zwischen zwei Kühldoseneinheiten mechanisch eingespannt. Die thermisch leitende Verbindung zwischen der elektrischen Komponente und der Kühldoseneinheit wird über eine Stirnfläche des Kühlkörpers hergestellt. Eine solche Anordnung bildet einen sogenannten Thyristor- oder Diodensäulenverband. Die Kühldoseneinheiten sind mit Anschlüssen ausgestattet, die eine Zufuhr des Kühlmittels ermöglichen. Das Kühlmittel transportiert Wärme zwischen den Scheibenthyristoren oder Scheibendioden und einem Kühlmittelreservoir beziehungsweise der äußeren Umgebung.

Aus der DE 967 450 C ist eine flüssigkeitsgekühlte Kühlvorrichtung mit einem Kühlkanal offenbart, der mit einem elektrolytisch korrosionsfestem Material überzogen ist.

In der EP 0 234 021 A1 ist die Wandung eines Kühlkanals einer Kühlvorrichtung mit einer elektrischen Isolierschicht überzogen.

Die WO 2009/052817 A2 offenbart eine weitere Kühlvorrichtung mit eine Korrosionsschutzschicht.

In der DE 34 08 771 A1 ist eine Möglichkeit beschrieben, durch zusätzliche Rippen im Kühlkanal den Querschnitt des Kühlkanals einzustellen.

Aus der DE 92 12 752 U1 ist ein Flüssigkeitskühlkörper bekannt, der einen Grundkörper aus Kunststoff und einer Kühlplatte umfasst.

Die Verwendung von entionisiertem Wasser als Kühlflüssigkeit ist aus der DE 43 01 865 A1 bekannt.

Die Aufgabe der Erfindung besteht darin, eine artgemäße Kühldoseneinheit vorzuschlagen, die eine möglichst zuverlässige Entwärmung der elektrischen Komponente ermöglicht.

Die Aufgabe wird bei einer artgemäßen Kühleinheit dadurch gelöst, dass der Kühlkörper kühlkanalseitig eine Schutzschicht aufweist, die eine Freisetzung von Metallionen in das den Kühlkanal durchströmende Kühlmittel verhindert.

Eigene Untersuchungen haben ergeben, dass die Zuverlässigkeit der Kühlung mittels der Kühldoseneinheit durch Verstopfungen der Kühlkanäle vermindert werden kann. Solche Verstopfungen haben ihre Ursache in der Freisetzung der Metallionen aus dem metallischen Kühlkörper in das den Kühlkanal durchfließende beziehungsweise durchströmende Kühlmittel. Durch Oxidation können die Metallionen in einem Kühlkreislauf, an den die Kühldoseneinheit angeschlossen ist, Ablagerungen bilden. Besonders starke Belagsbildung wurde nach eigenen Untersuchungen im Bereich einiger Bauteile im Kühlkreislauf festgestellt. Hat der Belag auf diesen Bauteilen eine gewisse Dicke erreicht, kann es zu Abplatzungen oder Absplitterungen des Belags oder Teilen davon kommen. Diese Abplatzungen und Absplitterungen werden untern Umständen durch den Kühlkreislauf gespült und lagern sich im Kühlkanal der Kühldoseneinheit an, was zur Verstopfung oder Verengung des Kühlkanals führt. Dadurch wird die Zirkulation des Kühlmittels behindert und die Zuverlässigkeit der Kühlwirkung mittels der Kühldoseneinheit vermindert.

Ein Vorteil der Erfindung besteht darin, dass die Schutzschicht, mit der die Innenfläche des Kühlkanals zumindest teilweise versehen ist, die Freisetzung der reaktiven Metallionen zumindest teilweise verhindert, wodurch die oben beschriebene Gefahr der Verstopfung des Kühlkanals vermindert werden kann. Der Kühlkörper kann aus einem sehr gut wärmeleitenden Material, wie beispielsweise Aluminium, hergestellt sein, denn ein direkter Kontakt zwischen dem Aluminium und dem Kühlmittel ist zumindest an denjenigen Stellen verhindert, die mit der Schutzschicht versehen sind.

Zudem ergibt sich ein Kostenvorteil gegenüber den marktüblichen Kühldoseneinheiten. Die erfindungsgemäße Kühldoseneinheit erlaubt eine Minderung der Servicekosten und eine vorteilhafte Verkürzung der Ausfallzeiten.

Für eine möglichst gute Kühlwirkung ist der Kühlkanal durch eine längliche Ausnehmung im Kühlkörper gebildet, deren Tiefe größer als die Öffnungsbreite der Ausnehmung ist. Der Abstand zwischen einer Bodenfläche der Ausnehmung und einer äußeren Stirn- oder Kühlfläche ist zweckmäßigerweise klein. Auf diese Weise ist ein besonders guter thermischer Kontakt zwischen dem Kühlmittel und der zu entwärmender elektrischer Komponente gegeben. Der Kühlkörper kann scheibenförmig ausgebildet sein, wobei die Größe der Kühlfläche gegenüber einer Seitenfläche geeigneterweise groß gewählt ist.

Die Kühldoseneinheit kann zwei gegenüber einander angeordnete Kühlkörper umfassen, die gleichartig aufgebaut sind. Im zusammengesetzten Zustand weisen die Kühlflächen der beiden Kühlkörper jeweils nach außen.

Die Kühldoseneinheit umfasst geeigneterweise wenigstens einen Kühlmittelanschluss, der beispielsweise an der Seitenfläche des Kühlkörpers angeordnet sein kann. Zweckmäßigerweise weist der Kühlmittelanschluss einen Zu- und Ablauf für das Kühlmittel auf und dient zum Zuführen und Abführen des Kühlmittels.

Vorzugsweise bildet der wenigstens eine Kühlkanal beispielsweise eine mäanderförmige oder spiralförmige Ausnehmung im Kühlkörper aus. Der Kanal erhält damit eine Ausprägung, die einen besonders guten Wärmetausch ermöglicht. Einzelne Teilabschnitte der Ausnehmung können einander angrenzend im Kühlkörper geführt sein, um die Fläche des Kühlkanals weiter zu vergrößern. Der Kühlkörper kann darüber hinaus eine Mehrzahl solcher Kühlkanäle ausbilden. Dabei ist jeder Kühlkanal geeigneterweise an wenigstens einem seiner Enden mit dem Kühlmittelanschluss verbunden.

Bevorzugt weist der Kühlkörper eine äußere scheibenförmige Kühlfläche zur Herstellung eines Wärmeübergangs zwischen der Kühldoseneinheit und der elektrischen Komponente auf. Die scheibenförmige Kühlfläche kann die zu entwärmende Komponente kontaktieren. Für einen verbesserten thermischen Kontakt kann die Kühlfläche an die elektrische Komponente mechanisch gepresst werden. Der Kühlkörper bzw. dessen Kühlfläche kann ebenfalls dazu geeignet sein, eine elektrisch leitende Verbindung mit der elektrischen Komponente herzustellen.

Gemäß einer Ausführungsform der Erfindung ist die Schutzschicht eine oxidische Schutzschicht. Dabei enthält die Schutzschicht Metalloxide, so dass keine reaktiven Metallionen in das Kühlmittel abgegeben werden. Die oxidierte Schutzschicht kann beispielsweise eine Eloxalbeschichtung sein. Die Eloxalbeschichtung kann beispielsweise durch Harteloxieren der kühlkanalseitigen Fläche des Kühlkörpers hergestellt werden. Denkbar sind jedoch auch andere Beschichtungen. Beispielsweise kann die Schutzschicht eine Edelmetallschicht sein. Eine solche Edelmetallschicht kann durch Versilbern gebildet werden. Weitere Varianten der Schutzschicht können Aluminiumoxid aber auch Keramiken und dergleichen enthalten. Die Bildung der Schutzschicht kann, muss jedoch nicht, beispielsweise galvanisch erreicht werden.

Erfindungsgemäß umfasst die Kühldoseneinheit einen mit dem Kühlkörper verbundenen Grundkörper, der den wenigstens einen Kühlkanal teilweise begrenzt. Ein solcher Aufbau der Kühldoseneinheit bietet herstellungstechnische Vorteile. Der Kühlkanal wird demnach sowohl durch den Kühlkörper als auch durch den Grundkörper begrenzt. Der Kühlkanal muss demnach nicht durch aufwändige Bohrung im Kühlkörper hergestellt werden, sondern wird mit einer relativ einfach herzustellenden Ausnehmung im Kühlkörper beim Zusammensetzen des Kühlkörpers und des Grundkörpers gebildet. Der wenigstens eine Kühlmittelanschluss kann am Grundkörper angeordnet sein. Umfasst die Kühldoseneinheit zwei beispielsweise formgleiche Kühlkörper, so können diese beidseitig des Grundkörpers angeordnet sein. Der Kühlkörper kann mit dem Grundkörper beispielsweise mittels Kleben, Schrauben oder dergleichen flüssigkeitsdicht mit dem Grundkörper verbunden sein. Vorzugsweise bildet der Grundkörper eine selbstdichtende Einheit mit dem Kühlkörper.

Zur Gewährleistung eines guten Wärmeaustausch und damit einer guten Kühlwirkung ist es von Vorteil, wenn der Kühlkanal derart geformt ist, dass die Strömung des Kühlmittels im Kühlkanal möglichst eine turbulente Komponente aufweist. Dazu darf der Durchflussquerschnitt des Kühlkanals nicht zu groß gewählt werden. Erfindungsgemäß weist daher der Grundkörper einen zum Kühlkanal teilweise formkomplementären Vorsprung zur Verkleinerung einer Kühlkanaltiefe auf. Durch die Begrenzung der Kühlkanaltiefe kann der Durchflussquerschnitt nach Bedarf reduziert werden, so dass die Strömung des Kühlmittels die gewünschten Eigenschaften aufweist. Der Vorsprung kann in dessen Querrichtung, die quer zur Längsrichtung des Kühlkanals gerichtet ist, beispielsweise eine Trapezform aufweisen.

Bevorzugt ist die Verbindung zwischen dem Kühlkörper und dem Grundkörper lötfrei. Auf diese Weise kann eine Beeinträchtigung der Schutzschicht durch eine Lotschicht vermieden werden.

Gemäß der Erfindung besteht der Grundkörper aus einem Kunststoff. Der Einsatz von Kunststoff als einem relativ schlecht wärmeleitenden Material ist insbesondere dadurch möglich, weil die Anordnung des Grundkörpers nicht direkt am Wärmeübergang zwischen dem Kühlmittel bzw. dem Kühlkörper und der zu entwärmenden Komponente vorgesehen ist. Besteht der Grundkörper aus Kunststoff, so kann er vorteilhaft zusätzlich eine Dichtfunktion ausüben.

Die Erfindung betrifft ferner eine leistungselektronische Einrichtung mit einer elektrischen Komponente mit weinigstens einem Leistungshalbleiter sowie einer Kühldoseneinheit zum Entwärmen der elektrischen Komponente, wobei die elektrische Komponente und die Kühldoseneinheit miteinander thermisch leitend in einem mechanischen Spannverband verbunden sind und die Kühldoseneinheit einen metallischen Kühlkörper zur Herstellung einer thermisch leitenden Verbindung mit der elektrischen Komponente und wenigstens einem Kühlkanal zur Führung eines Kühlmittel umfasst, wobei der Kühlkörper den wenigstens einem Kühlkanal zumindest teilweise ausbildet, wobei der Kühlkanal an einen Kühlkreislauf angeschlossen ist, in dem der Kühlkanal fortgeführt ist.

Eine solche leistungselektronische Einrichtung ist aus der bereits genannten EP 0 021 269 A2 bekannt. Der Kühlkreislauf verfügt über entsprechende Leitungen, die mit dem Kühlkanal verbunden sind und so den Kühlkanal fortführen. Er dient zur Gewährleistung einer Zirkulation des Kühlmittels.

Die Aufgabe der Erfindung ist es, eine artgemäße leistungselektronische Einrichtung vorzuschlagen, die möglichst zuverlässig ist.

Die Aufgabe wird durch eine leistungselektronische Einrichtung mit den Merkmalend des Anspruchs 6 gelöst.

Mit anderen Worten sind der Kühlkörper und/oder ein weiterer Teil des Kühlkreislaufes zumindest teilweise mit der Schutzschicht versehen. Vorteilhafterweise ist die Schutzschicht dort vorgesehen, wo das metallische Material des Kühlkörpers oder des Teils des Kühlkreislaufes mit dem Kühlmittel in Verbindung kommt.

Die Vorteile der erfindungsgemäßen leistungselektronischen Einrichtung ergeben sich aus den zuvor beschriebenen Vorteilen der erfindungsgemäßen Kühldoseneinheit. Insbesondere können alle zuvor beschriebenen Merkmale und Varianten der Kühldoseneinheit alleinstehend oder in Kombination auch im Zusammenhang mit der erfindungsgemäßen leistungselektronischen Einrichtung realisiert werden.

Gemäß einer Ausführungsform der Erfindung umfasst die elektrische Komponente Leistungshalbleiterschalter.

Vorzugsweise umfasst das Kühlmittel entionisiertes Wasser und/oder Glykol. Diese Stoffe haben sich als besonders gute Wärmetransportstoffe erwiesen, die zudem elektrisch nichtleitend sind.

Als besonders vorteilhaft wird angesehen, wenn die leistungselektronische Einrichtung für Spannungen oberhalb von 10 kV ausgelegt ist. In diesem Spannungsbereich fließen durch die elektrische Komponente hohe Ströme, insbesondere im Bereich oberhalb von 1 kA. Aufgrund dieser Ströme besteht in diesen Fällen besonders hoher Bedarf nach einer effizienten und zuverlässigen Entwärmung der elektrischen Komponente bzw. Komponenten der leistungselektronischen Einrichtung.

Gemäß einer Ausführungsform der Erfindung bildet die leistungselektronische Einrichtung zumindest einen Teil eines Stromrichterventils aus. Das Stromrichterventil ist dabei beispielsweise in einem Stromrichter einer Hochspannungsgleichstromübertragungsanlage eingesetzt. Die elektrische Komponente kann beispielsweise ein Thyristor-Baustein oder ein IGBT-Modul sein.

Die Erfindung soll im Folgenden anhand von Figuren 1 bis 4 weiter erläutert werden.
Figur 1 zeigt ein erstes Ausführungsbeispiel einer erfindungsgemäßen Kühldoseneinheit in einer schematischen Querschnittsansicht;
Figur 2 zeigt ein zweites Ausführungsbeispiel einer erfindungsgemäßen Kühldoseneinheit in einer schematischen Querschnitts-Teilansicht;
Figur 3 zeigt ein drittes Ausführungsbeispiel einer erfindungsgemäßen Kühldoseneinheit in einer schematischen Übersichtsdarstellung;
Figur 4 zeigt ein Ausführungsbeispiel einer erfindungsgemäßen leistungselektronischen Einrichtung in einer schematischen Darstellung.

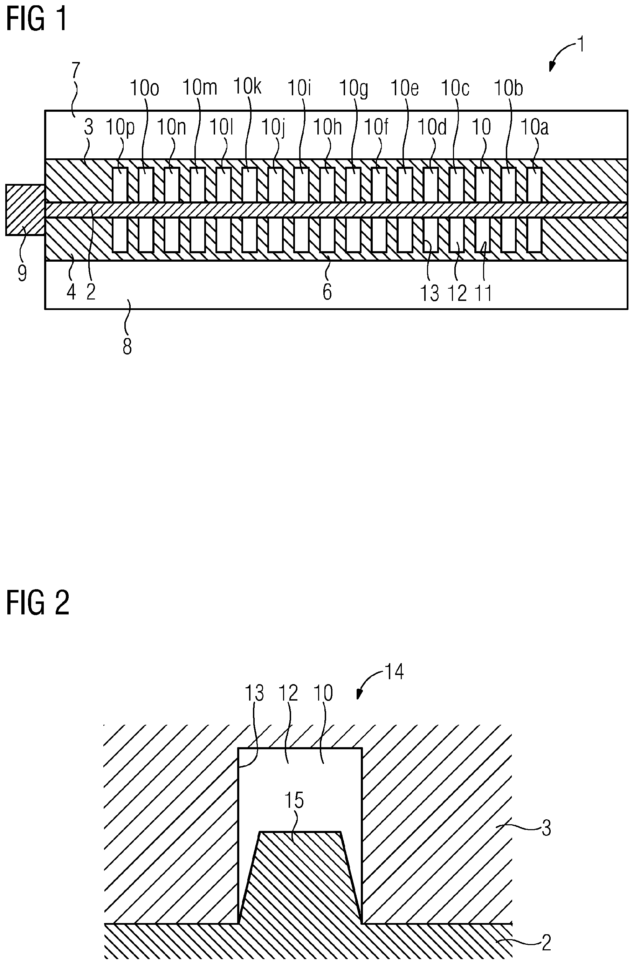

Im Einzelnen ist in Figur 1 eine Kühldoseneinheit 1 dargestellt. Die Kühldoseneinheit 1 umfasst einen scheibenförmigen bzw. plattenförmigen Grundkörper 2. Beidseitig des Grundkörpers 2 sind ein erster Kühlkörper 3 und ein zweiter Kühlkörper 4 angeordnet. Abgewandt vom Grundkörper 2 weisen der erste und der zweite Kühlkörper 3 bzw. 4 jeweils eine äußere scheibenförmige Kühlfläche 5 bzw. 6 auf. Die Kühlflächen 5, 6 stellen einen Wärmeübergang zwischen der Kühldoseneinheit 1 und einer ersten bzw. einer zweiten elektrischen Komponente 7 bzw. 8 her. Die erste und zweite elektrische Komponente 7 bzw. 8 sind im dargestellten Ausführungsbeispiel Scheibenthyristoren, die in einem mechanischen Spannverband mit der Kühldoseneinheit 1 verspannt sind. Die Kühldoseneinheit 1 und die Scheibenthyristoren 7 und 8 bilden einen Teil eines grafisch nicht vollständig gezeigten Säulenspannverbandes. Seitlich am Grundkörper 2 ist ein Kühlmittelanschluss 9 angeordnet. Mittels des Kühlmittelanschlusses 9 wird ein Kühlmittel, im dargestellten Ausführungsbeispiel entionisiertes Wasser, zwischen der Kühldoseneinheit 1 und einem in Figur 1 grafisch nicht dargestellten Kühlkreislauf ausgetauscht.

Der erste Kühlkörper 3 und der zweite Kühlkörper 4 sind gleichartig aufgebaut. Der erste Kühlkörper 3 weist eine längliche Ausnehmung 10 auf, die sich bezogen auf die Darstellung der Figur 1 senkrecht zur Zeichenebene länglich erstreckt. Die Ausnehmung 10 weist bezüglich ihrer Längsausdehnung eine gewundene Mäanderform auf, so dass die Ausnehmung 10 in der Querschnittsdarstellung der Figur 1 als eine Vielzahl von nebeneinander angeordneten Hohlräumen 10a-10p erscheint. Durch die Ausnehmung 10 und den Grundkörper 2 ist ein Kühlkanal 12 zur Führung des Kühlmittels begrenzt.

In der Figur 1 ist erkennbar, dass die Tiefe der Ausnehmung 10 größer als deren Breite ist. Der kleine Abstand zwischen der Bodenfläche 11 der Ausnehmung 10 und der Kühlfläche 5 sorgt für einen möglichst guten Wärmeaustausch zwischen der zu entwärmenden ersten elektrischen Komponente 7 und dem Kühlmittel, das den Kühlkanal 12 durchfließt.

Der Grundkörper 2 ist aus einem Kunststoffmaterial und sorgt selbstdichtend für eine verbesserte Flüssigkeitsdichtung zwischen den Kühlkörpern 3, 4 und dem Grundkörper 2, Die Verbindung zwischen dem Grundkörper 2 und den Kühlkörpern 3, 4 mittels Verschraubung hergestellt ist.

Die Kühlkörper 3 und 4 sind aus Aluminium gefertigt. Auf der dem Kühlkanal 12 zugewandten Oberfläche der Kühlkörper 3, 4 sind die beiden Kühlkörper 3, 4 mit einer Eloxal-Schutzschicht 13 versehen. Die Schutzschicht 13 verhindert ein Freisetzen von reaktiven Aluminium-Ionen in das den Kühlkanal 12 (und dessen Entsprechung im zweiten Kühlkörper 4) durchfließende Kühlmittel.

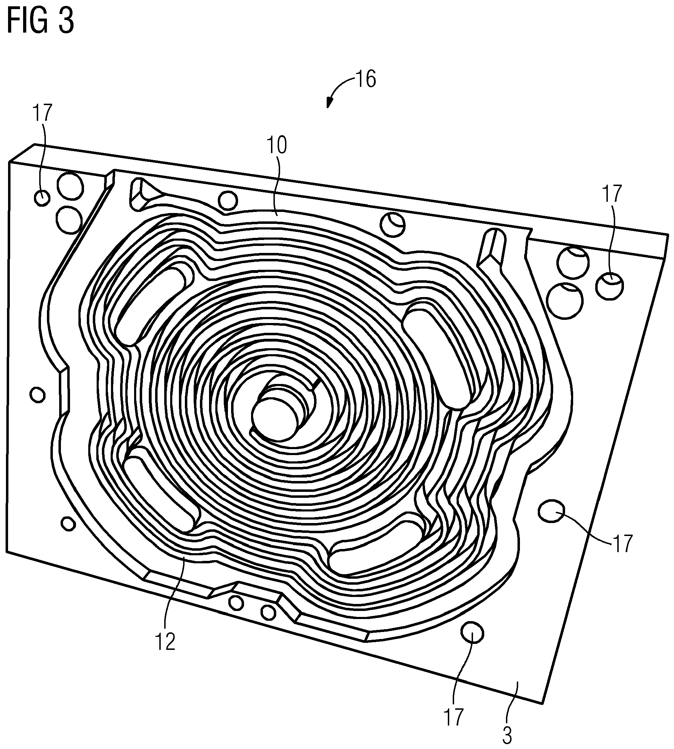

In Figur 2 ist ein Ausschnitt einer Kühldoseneinheit 14 dargestellt. Aus Gründen der Übersichtlichkeit sind in den Figuren 1 und 2 gleiche und gleichartige Teile der Kühldoseneinheiten 1 und 14 mit gleichen Bezugszeichen versehen. Gleiches gilt auch für die nachfolgende Figur 3. In Figur 2 ist die Ausnehmung 10 im ersten Kühlkörper 3 der Kühldoseneinheit 14 veranschaulicht. Die Ausnehmung 10 begrenzt zusammen mit dem Grundkörper 2 den Kühlkanal 12 der Kühldoseneinheit 14. Der Grundkörper 2 der Kühldoseneinheit 14 unterscheidet sich vom Grundkörper 2 der Kühldoseneinheit 1 dadurch, dass der Grundkörper 2 der Kühldoseneinheit 14 einen Vorsprung 15 aufweist, der sich in den Kühlkanal 12 entlang dessen Längsausdehnung erstreckt. Der Vorsprung 15 ist trapezförmig und hat die Funktion, den Querschnitt bzw. die Kühlkanaltiefe des Kühlkanals 12 zu verkleinern. Durch diese Reduktion der Durchlässigkeit des Kühlkanals 12 für das Kühlmittel können die Strömungseigenschaften und damit auch die Kühlwirkung der Kühldoseneinheit 14 weiter verbessert werden.

Figur 3 zeigt eine Übersichtsdarstellung einer Kühldoseneinheit 16, wobei in der Darstellung der Figur 3 lediglich der erste Kühlkörper 3 grafisch gezeigt ist. In Figur 3 ist die Ausnehmung 10 im metallischen Kühlkörper 3 erkennbar. Die Ausnehmung 10 erstreckt sich mäanderförmig im Kühlkörper und begrenzt teilweise den Kühlkanal 12 zur Führung des Kühlmittels. Der Kühlkörper 3 weist eine Mehrzahl von Bohröffnungen 17 auf, die zur Verbindung des Kühlkörpers 3 mit einem in Figur 3 nicht dargestellten Grundkörper vorgesehen sind.

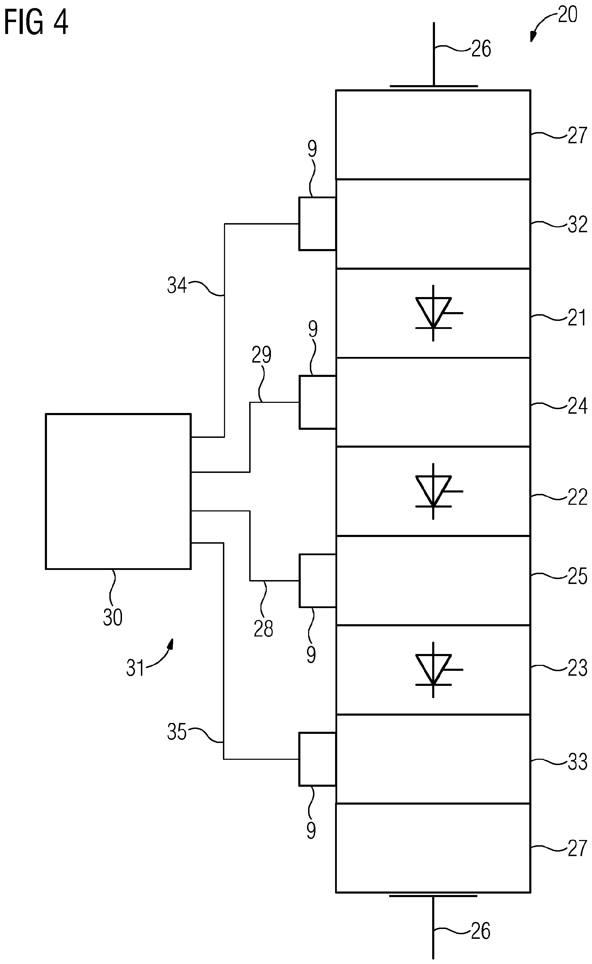

In Figur 4 ist eine leistungselektronische Einrichtung 20 in Form eines Säulenspannverbandes dargestellt. Die Einrichtung 20 umfasst mehrere elektrische Komponenten 21-23. Die elektrischen Komponenten 21-23 sind im dargestellten Ausführungsbeispiel Scheibenthyristoren, die in einer elektrischen Reihenschaltung miteinander verbunden sind. Zwischen den Scheibenthyristoren 21-23 befinden sich Kühldoseneinheiten 24 und 25 zum Entwärmen der Scheibenthyristoren 21-23. Weitere Kühldoseneinheiten 32 und 33 sind jeweils zwischen einem der Druckstücke 27 und Scheibenthyristoren 21 bzw. 23 angeordnet. Der Säulenspannverband wird mechanisch durch eine Spannvorrichtung erzeugt, wobei die mechanische Kraft von einer Spannvorrichtung 26 und über geeignete Druckstücke 27 auf die Scheibenthyristoren 21-23 und die Kühldoseneinheiten 24, 25, 32, 33 übertragen wird. Der Aufbau der Kühldoseneinheiten 24, 25, 32, 33 entspricht jeweils dem Aufbau einer der Kühldoseneinheiten 1, 14 oder 16.

Jede Kühldoseneinheit 24, 25, 32, 33 umfasst einen Kühlmittelanschluss 9 zum Anschluss an einen Kühlkreislauf 31 mit einem Zu- und Ablauf für das Kühlmittel. Der Kühlkreislauf 31 umfasst eine Vielzahl von Leitungen, wovon in Figur 4 die Leitungen 28, 29, 34, 35 zwischen den Kühldoseneinheiten 24, 25, 32, 33 und einer zentralen Kühlmittelvorratsstation 30 grafisch dargestellt sind. Sowohl die Innenseiten der Leitungen 28, 29, 34, 35 als auch die Kühlkanäle 10 in den Kühldoseneinheiten 24, 25, 32 und 33 sind zumindest teil- oder abschnittsweise mit einer Schutzschicht versehen, die eine Freisetzung von reaktiven Aluminiumionen in das Kühlmittel reduzieren oder verhindern.

## Patentansprüche

1. Kühldoseneinheit (1) zum Entwärmen einer elektrischen Komponente (7, 8) mit einem metallischen Kühlkörper (3, 4) zur Herstellung einer thermisch leitenden Verbindung mit der elektrischen Komponente (7, 8) und wenigstens einem Kühlkanal (12) zur Führung eines Kühlmittels, wobei der Kühlkörper (3, 4) den wenigstens einen Kühlkanal (12) zumindest teilweise ausbildet, wobei der Kühlkanal durch eine längliche Ausnehmung im Kühlkörper gebildet ist, deren Tiefe größer als eine Öffnungsbreite der Ausnehmung ist, wobei der Kühlkörper kühlkanalseitig eine Schutzschicht (13) aufweist, die eine Freisetzung von Metallionen in das den Kühlkanal (12) durchströmende Kühlmittel verhindert, wobei die Kühldoseneinheit (1) einen mit dem Kühlkörper verbundenen Grundkörper (2) umfasst, der den wenigstens einen Kühlkanal (12) teilweise begrenzt, **dadurch gekennzeichnet, dass** der Grundkörper (2) aus einem Kunststoff besteht, wobei der Grundkörper (2) einen zum Kühlkanal (12) teilweise formkomplementären Vorsprung (15) zur Verkleinerung einer Kühlkanaltiefe aufweist.

2. Kühldoseneinheit (1) nach Anspruch 1, wobei der wenigstens eine Kühlkanal (12) eine mäanderförmige oder spiralförmige Ausnehmung (10) im Kühlkörper (3, 4) ausbildet.

3. Kühldoseneinheit (1) nach einem der vorangehenden Ansprüche, wobei der Kühlkörper (3, 4) eine äußere scheibenförmige Kühlfläche (5, 6) zur Herstellung eines Wärmeübergangs zwischen der Kühldoseneinheit (1) und der elektrischen Komponente (7, 8) aufweist.

4. Kühldoseneinheit (1) nach einem der vorangehenden Ansprüche, wobei die Schutzschicht (13) eine oxidische Schutzschicht ist.

5. Kühldoseneinheit (1) nach einem der Anspruch 1, wobei die Verbindung zwischen dem Kühlkörper (3, 4) und dem Grundkörper (2) lötfrei ist.

6. Leistungselektronische Einrichtung (20) mit einer elektrischen Komponente (21 - 23) mit wenigstens einem Leistungshalbleiter sowie einer Kühldoseneinheit (24, 25) zum Entwärmen der elektrischen Komponente (21 - 23), wobei die elektrische Komponente (21 - 23) und die Kühldoseneinheit (24, 25) miteinander thermisch leitend in einem mechanischen Spannverband (21 - 27) verbunden sind und die Kühldoseneinheit (24, 25) einen metallischen Kühlkörper (3, 4) zur Herstellung einer thermisch leitenden Verbindung mit der elektrischen Komponente (21 - 23) und wenigstens einen Kühlkanal (12) zur Führung eines Kühlmittel umfasst, wobei der Kühlkörper (3, 4) den wenigstens einen Kühlkanal (12) zumindest teilweise ausbildet, wobei der Kühlkanal durch eine längliche Ausnehmung im Kühlkörper gebildet ist, deren Tiefe größer als eine Öffnungsbreite der Ausnehmung ist, wobei der Kühlkanal (12) an einen Kühlkreislauf (31) angeschlossen ist, in dem der Kühlkanal (12) fortgeführt ist, der Kühlkörper (3, 4) und/oder der Kühlkreislauf (31) kühlkanalseitig zumindest teilweise mit einer Schutzschicht (13) versehen sind, die eine Freisetzung von Metallionen in das den Kühlkanal (12) durchfließendes Kühlmittel verhindert, wobei die Kühldoseneinheit (1) einen mit dem Kühlkörper verbundenen Grundkörper (2) umfasst, der den wenigstens einen Kühlkanal (12) teilweise begrenzt, **dadurch gekennzeichnet dass** der Grundkörper (2) aus einem Kunststoff besteht, wobei der Grundkörper (2) einen zum Kühlkanal (12) teilweise formkomplementären Vorsprung (15) zur Verkleinerung einer Kühlkanaltiefe aufweist.

7. Leistunselektronische Einrichtung (20) nach Anspruch 6, wobei die elektrische Komponente (21 - 23) Leistungshalbleiterschalter umfasst.

8. Leistungselektronische Einrichtung (20) nach einem der Ansprüche 6 oder 7, wobei das Kühlmittel entionisiertes Wasser und/oder Glykol umfasst.

9. Leistungselektronische Einrichtung (20) nach einem der Ansprüche 6 bis 8, wobei die Leistungselektronische Einrichtung (20) für Spannungen oberhalb von 10 kV ausgelegt ist.

10. Leistungselektronische Einrichtung (20) nach einem der Ansprüche 6 bis 9, wobei die leistungselektronische Einrichtung zumindest einen Teil eines Stromrichterventils ausbildet.

## Claims

1. Cooling box unit (1) for dissipating heat from an electrical component (7, 8) comprising a metallic heat sink (3, 4) for producing a thermally conductive connection to the electrical component (7, 8) and at least one cooling duct (12) for guiding a coolant, wherein the heat sink (3, 4) at least partly forms the at least one cooling duct (12), wherein the cooling duct is formed by an elongate recess in the heat sink, the depth of which is greater than an opening width of the recess, wherein on the cooling duct side the heat sink has a protective layer (13) that prevents metal ions from being released into the coolant flowing through the cooling duct (12), wherein the cooling box unit (1) comprises a main body (2), which is connected to the heat sink and partly delimits the at least one cooling duct (12), **characterized in that** the main body (2) consists of a plastic, wherein the main body (2) has a projection (15) partly complementary to the cooling duct (12) in shape, for reducing a cooling duct depth.

2. Cooling box unit (1) according to Claim 1, wherein the at least one cooling duct (12) forms a meandering or spiral recess (10) in the heat sink (3, 4).

3. Cooling box unit (1) according to either of the preceding claims, wherein the heat sink (3, 4) has an outer disc-shaped cooling surface (5, 6) for producing a heat transfer between the cooling box unit (1) and the electrical component (7, 8).

4. Cooling box unit (1) according to any of the preceding claims, wherein the protective layer (13) is an oxidic protective layer.

5. Cooling box unit (1) according to Claim 1, wherein the connection between the heat sink (3, 4) and the main body (2) is free of soldering.

6. Power electronic device (20) comprising an electrical component (21-23) comprising at least one power semiconductor and also a cooling box unit (24, 25) for dissipating heat from the electrical component (21-23), wherein the electrical component (21-23) and the cooling box unit (24, 25) are thermally conductively connected to one another in a mechanical clamping assembly (21-27) and the cooling box unit (24, 25) comprises a metallic heat sink (3, 4) for producing a thermally conductive connection to the electrical component (21-23) and at least one cooling duct (12), for guiding a coolant, wherein the heat sink (3, 4) at least partly forms the at least one cooling duct (12), wherein the cooling duct is formed by an elongate recess in the heat sink, the depth of which is greater than an opening width of the recess, wherein the cooling duct (12) is connected to a cooling circuit (31) in which the cooling duct (12) is continued, on the cooling duct side the heat sink (3, 4) and/or the cooling circuit (31) are/is provided at least partly with a protective layer (13) that prevents metal ions from being released into the coolant flowing through the cooling duct (12), wherein the cooling box unit (1) comprises a main body (2), which is connected to the heat sink and partly delimits the at least one cooling duct (12), **characterized in that** the main body (2) consists of a plastic, wherein the main body (2) has a projection (15) partly complementary to the cooling duct (12) in shape, for reducing a cooling duct depth.

7. Power electronic device (20) according to Claim 6, wherein the electrical component (21-23) comprises power semiconductor switches.

8. Power electronic device (20) according to either of Claims 6 and 7, wherein the coolant comprises deionized water and/or glycol.

9. Power electronic device (20) according to any of Claims 6 to 8, wherein the power electronic device (20) is designed for voltages of above 10 kV.

10. Power electronic device (20) according to any of Claims 6 to 9, wherein the power electronic device forms at least part of a converter valve.

## Revendications

1. Unité (1) de boîte de refroidissement pour la dissipation de la chaleur d'un composant (7, 8) électrique, comprenant un puits de chaleur (3, 4) métallique pour produire une liaison conductrice thermiquement avec le composant (7, 8) électrique et au moins un conduit (12) de refroidissement pour conduire un fluide de refroidissement, le puits de chaleur (3, 4) constituant, au moins en partie, le au moins un conduit (12) de refroidissement, le conduit de refroidissement étant formé d'un évidement oblong dans le puits de chaleur, dont la profondeur est plus grande qu'une largeur d'ouverture de l'évidement, dans laquelle le puits de chaleur a, du côté du conduit de refroidissement, une couche (13) de protection, qui empêche une libération d'ions métalliques dans le fluide de refroidissement passant dans le conduit (12) de refroidissement, dans laquelle
l'unité (1) de boîte de refroidissement comprend une embase (2), qui est reliée au puits de chaleur et qui délimite en partie au moins un conduit (12) de refroidissement, **caractérisé en ce que**
l'embase (2) est en une matière plastique, l'embase (2) ayant, pour la diminution d'une profondeur du conduit de refroidissement, une saillie (15) de forme complémentaire, au moins en partie, du conduit (12) de refroidissement.

2. Unité (1) de boîte de refroidissement suivant la revendication 1, dans laquelle le au moins un conduit (12) de refroidissement constitue, dans le puits de chaleur (3, 4), un évidement (10) sinueux ou en spirale.

3. Unité (1) de boîte de refroidissement suivant l'une des revendications précédentes, dans laquelle le puits de chaleur (3, 4) a une surface (5, 6) de refroidissement extérieure en forme de disque pour la production d'un transfert de chaleur entre l'unité (1) de boîte de refroidissement et le composant (7, 8) électrique.

4. Unité (1) de boîte de refroidissement suivant l'une des revendications précédentes, dans laquelle la couche (13) de protection est une couche de protection par voie d'oxydation.

5. Unité (1) de boîte de refroidissement suivant l'une des revendications 1, dans laquelle la liaison entre le puits de chaleur (3, 4) et l'embase (2) est sans brasure.

6. Dispositif (20) électronique de puissance comprenant un composant (21 à 23) électrique, comprenant au moins un semi-conducteur de puissance, ainsi qu'une unité (24, 25) de boîte de refroidissement pour la dissipation de la chaleur du composant (21 à 23) électrique, le composant (21 à 23) électrique et l'unité (24, 25) de boîte de refroidissement étant reliés entre eux d'une manière conductrice thermiquement dans un système (21 à 27) mécanique de serrage et l'unité (24, 25) de boîte de refroidissement comprenant un puits de chaleur (3, 4) métallique pour la production d'une liaison conductrice thermiquement avec le composant (21 à 23) électrique et au moins un conduit (12) de refroidissement pour conduire un fluide de refroidissement, le puits de chaleur (3, 4) formant, au moins en partie, le au moins un conduit (12) de refroidissement, le conduit de refroidissement étant formé d'un évidement oblong dans le puits de chaleur, dont la profondeur est plus grande qu'une largeur d'ouverture de l'évidement, le conduit (12) de refroidissement communiquant avec un circuit (31) de refroidissement où le conduit (12) de refroidissement se prolonge,
le puits de chaleur (3, 4) et/ou le circuit (31) de refroidissement sont pourvus, du côté du conduit de refroidissement, au moins en partie, d'une couche (13) de protection, qui empêche la libération d'ions métalliques dans le fluide de refroidissement passant dans le conduit (12) de refroidissement,
dans lequel
l'unité (1) de boîte de refroidissement comprend une embase (2), qui est reliée au puits de chaleur et qui délimite en partie au moins un conduit (12) de refroidissement, **caractérisé en ce que**
l'embase (2) est en une matière plastique, l'embase (2) ayant, pour la diminution d'une profondeur du conduit de refroidissement, une saillie (15) de forme complémentaire, au moins en partie, du conduit (12) de refroidissement.

7. Dispositif (20) électronique de puissance suivant la revendication 6,
dans lequel le composant (21 à 23) électrique comprend des interrupteurs à semi-conducteur de puissance.

8. Dispositif (20) électronique de puissance suivant l'une des revendications 6 ou 7,
dans lequel le fluide de refroidissement comprend de l'eau déminéralisée et/ou du glycol.

9. Dispositif (20) électronique de puissance suivant l'une des revendications 6 à 8,
dans lequel le dispositif (20) électronique de puissance est conçu pour des tensions au-dessus de 10 kV.

10. Dispositif (20) électronique de puissance suivant l'une des revendications 6 à 9,
dans lequel le dispositif électronique de puissance constitue au moins une partie d'une soupape de convertisseur.
